Europäisches Patentamt

European Patent Office

Office européen des brevets

(19)

(11) Numéro de publication : **0 052 033**
**B1**

(12) # FASCICULE DE BREVET EUROPÉEN

(45) Date de publication du fascicule du brevet :
**11.05.83**

(51) Int. Cl.³ : **H 01 L 31/10**

(21) Numéro de dépôt : **81401633.3**

(22) Date de dépôt : **16.10.81**

(54) **Phototransistor à hétérojonction en technologie planar, et procédé de fabrication d'un tel phototransistor.**

(30) Priorité : **12.11.80 FR 8024036**

(43) Date de publication de la demande :
**19.05.82 Bulletin 82/20**

(45) Mention de la délivrance du brevet :
**11.05.83 Bulletin 83/19**

(84) Etats contractants désignés :
**DE GB NL**

(56) Documents cités :
**ELECTRONIC LETTERS, volume 16, no. 1, janvier 1980 HITCHIN HERTS (GB) D. ANKRI et al. « Design and evaluation of a planar GaAlAs-GaAs bipolar transistor », pages 41-42**

(73) Titulaire : **THOMSON-CSF
173, Boulevard Haussmann
F-75379 Paris Cedex 08 (FR)**

(72) Inventeur : **Poulain, Pierre
THOMSON-CSF SCPI 173, bld Haussmann
F-75379 Paris Cedex 08 (FR)**
Inventeur : **de Cremoux, Baudoin
THOMSON-CSF SCPI 173, bld Haussmann
F-75379 Paris Cedex 08 (FR)**
Inventeur : **Hirtz, Pierre
THOMSON-CSF SCPI 173, bld Haussmann
F-75379 Paris Cedex 08 (FR)**

(74) Mandataire : **Giraud, Pierre et al
THOMSON-CSF SCPI 173, Bld Haussmann
F-75379 Paris Cedex 08 (FR)**

Jouve, 18, rue St-Denis, 75001 Paris, France

Phototransistor a hétérojonction en technologie planar et procédé de fabrication d'un tel phototransistor

L'invention concerne un phototransistor à hétérojonction en technologie plane, dite « planar », ainsi qu'un procédé de fabrication de celui-ci.

On sait que les phototransistors du type planar sont fabriqués par épitaxie successives sur un substrat cristallin à partir de matériaux semiconducteurs appartenant :

— soit à un système ternaire : Ga, Al, As ;

— soit un système quaternaire : Ga, In, As, P.

Or on rencontre, dans cette technologie, les difficultés suivantes :

1. La connexion électrique du dispositif, avec contact de bonne qualité, pour la couche intermédiaire, est difficile à réaliser, en raison :

de la situation de cette couche, moins accessible que les couches extrêmes, par le substrat ou par la face supérieure libre du phototransistor ;

de sa minceur, l'épaisseur courante de cette couche, dans un phototransistor à hétérojonction, étant de l'ordre du micron

2. La position de la jonction p-n est difficile à contrôler exactement en raison de la diffusion possible du dopant d'une couche pendant l'épitaxie de la suivante. C'est notamment le cas, dans le système quaternaire, en transistor n-p-n, pour la diffusion de l'impureté de type $p^+$ de la couche intermédiaire (base) qui est susceptible de diffuser relativement loin dans la couche supérieure (émetteur), provoquant ainsi une diminution importante du coefficient d'amplification du phototransistor.

L'invention vise à éliminer ces difficultés en adoptant une nouvelle structure et un procédé de fabrication adapté à celle-ci.

Le phototransistor selon l'invention comporte :

— un substrat constitué par un premier matériau semiconducteur fortement dopé dans un premier type de conductivité ;

— une première couche semiconductrice constituée par un deuxième matériau semiconducteur à bande interdite déterminée pour absorber un rayonnement de longueur d'onde prédéterminée ;

— une deuxième couche semiconductrice, constituée par un troisième matériau semiconducteur à bande interdite plus grande que celle du deuxième matériau.

Il est caractérisé en ce que :

— la première couche présente un dopage moins élevé que le substrat dans le même type de conductivité en ce qui concerne une première région en contact avec le substrat et un dopage du type opposé dans une deuxième région s'étendant à travers une partie de la surface de ladite première couche faisant face au rayonnement incident ;

— la deuxième couche comporte une troisième région de même type de conductivité que le substrat occupant toute l'épaisseur de la deuxième couche et une partie relativement faible de sa largeur, la troisième région étant entourée d'une quatrième région de type opposé de conductivité se raccordant à la deuxième région de la première couche.

L'invention sera mieux comprise, et d'autres caractéristiques apparaîtront, au moyen de la description qui suit, et des dessins qui l'accompagnent, parmi lesquels :

la figure 1 représente en coupe schématique un phototransistor selon l'invention ;

la figure 2 est une vue par dessus d'un phototransistor selon l'invention ;

les figures 3 à 5 représentent des étapes de fabrication du phototransistor ;

la figure 6 représente, vue par dessus, une variante de l'invention.

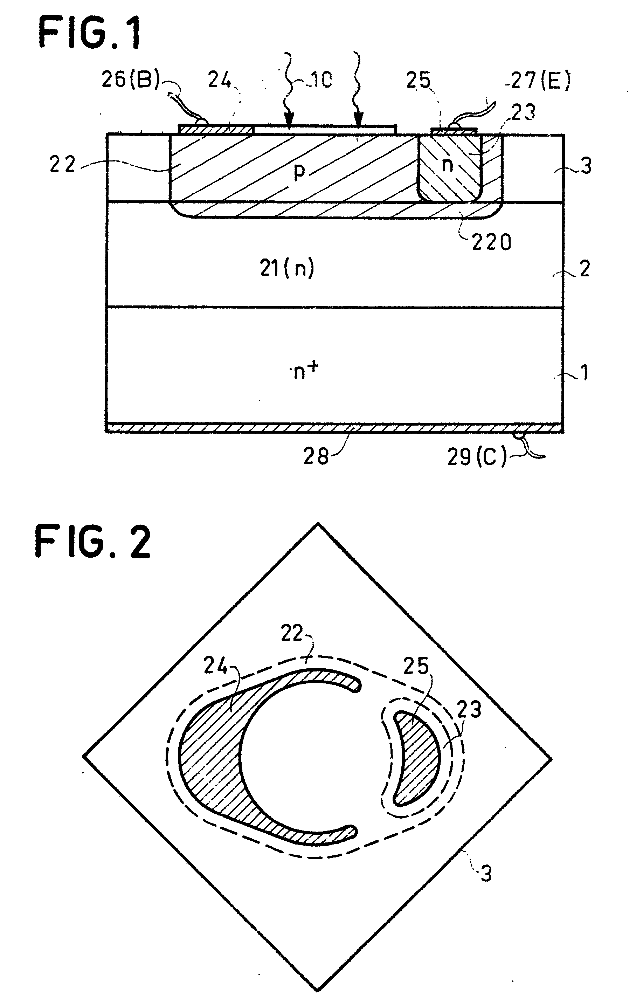

Le bloc semiconducteur qui forme la partie essentielle du phototransistor (représenté en coupe à la figure 1) comporte :

— un substrat 1 en matériau semiconducteur monocristallin, par exemple en phosphure d'indium, dopé $n^+$ (concentration supérieure ou égale à $10^{17}$ at.cm$^{-3}$) ;

— une première couche 2, semiconductrice, en matériau de composition donnée par la formule :

$$Ga_x In_{1-x} As_y P_{1-y}$$

avec

$$0,05 \leqslant x \leqslant 0,47$$

et

$$0 < y < 1$$

x et y étant choisis dans les intervalles ci-dessus en respectant la relation :

$$x = 0,19\ y/0,42 - 0,013\ y$$

qui est la condition à réaliser pour que le réseau monocristallin soit compatible avec celui du substrat 1, en pratique à 1 % près, le dopage initial de cette couche (région 21) étant réalisé par une concentration de $10^{15}$ à $10^{17}$ at.cm$^{-3}$ d'une impureté de type n ;

— une deuxième couche 3 semiconductrice en matériau de composition donnée par la formule :

$$Ga_{x'} In_{1-x'} As_{y'} P_{1-y'}$$

où x' et y' sont choisis dans les mêmes intervalles que pour la première couche, en respectant la même relation, avec en outre la condition :

$$x' < x$$

le dopage initial de cette couche 3 étant de type indifférent mais toutefois assez faible pour ne pas gêner les opérations de dopages localisées qui sont :

a) dans la région 22 une diffusion d'une impureté de type p permettant d'obtenir une concentration de $10^{15}$ à $10^{17}$ at.cm$^{-3}$, poussée jusqu'à ce que le dopage pénètre dans une partie de la couche 2 (région 220) ;

b) dans la région 23 une implantation, dans toute l'épaisseur de la couche 3, d'une impureté de type n avec une concentration finale de $10^{15}$ à $10^{17}$ at.cm$^{-3}$.

Les épaisseurs sont les suivantes :

— pour la couche 2, de 1 à 10 microns, mais de préférence en restant dans l'intervalle allant de 1,5 (pour une concentration de $10^{17}$ at.cm$^{-3}$) à 4 microns (pour $10^{15}$ at.cm$^{-3}$). L'épaisseur de 1,5 micron est un minimum pour absorber une quasi-totalité de la lumière en un seul passage ; il est vrai que cette épaisseur pourrait être moindre dans l'exemple choisi sans compromettre l'absorption de photons en raison de la propriété de InP d'être transparent pour la lumière absorbée par le matériau quaternaire. Des réflexions successives peuvent alors avoir lieu sur la face métallisée du substrat et permettre une absorption de lumière au cours de traversées successives de la couche 2 ;

— pour la couche 3 une épaisseur de 0,2 à 0,3 micron, l'impureté implantée dans le cas du phosphure d'indium, de gallium et d'arsenic étant constituée par des ions silicium lancés par un implanteur ionique.

Pour compléter le phototransistor, on réalise des métallisations 24 et 25 sur les régions 22 et 23, respectivement, puis 28 sur la face libre du substrat. La métallisation 24 est en forme de fer à cheval comme le montre la figure 2 qui est une vue par dessus du phototransistor. Elle entoure une zone 20 de forme circulaire située au centre et destinée à recevoir les rayons lumineux 10 (figure 1). Des connexions de raccordement électrique 28(B), 27(E) et 29(C) sont soudées aux métallisations (figure 1) pour constituer les accès à la base, à l'émetteur et au collecteur du phototransistor, respectivement. Le fonctionnement du phototransistor ainsi réalisé est classique : la jonction pn du transistor npn étant polarisée en inverse, les photons absorbés par la couche 2 donnent naissance à des paires électrons-trous qui génèrent le courant primaire, amplifié par effet transistor et donnant lieu à un courant collecteur que l'on détecte pour mesurer la quantité de photons reçue.

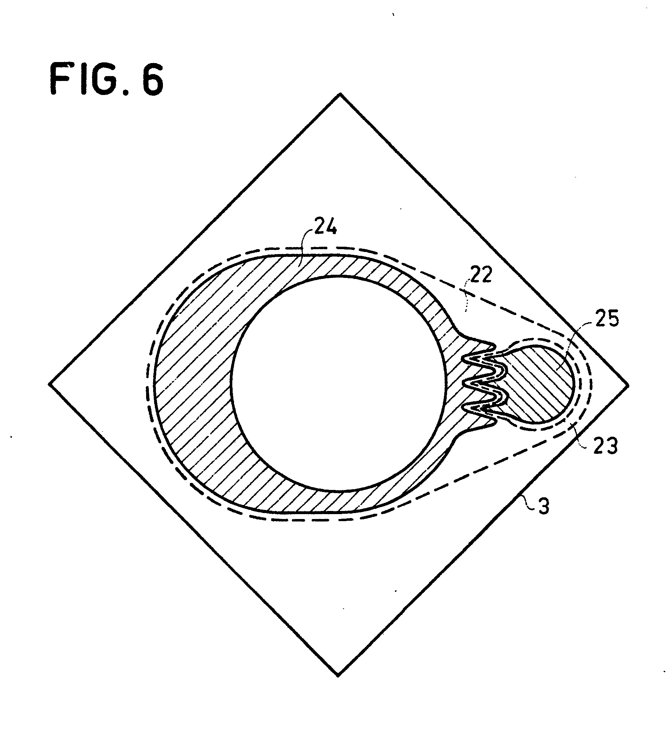

Parmi les avantages de l'invention, on note la facilité de réalisation des connexions de base et d'émetteur. En outre, selon une variante représentée à la figure 6, on peut interdigiter les régions 22 et 23 et les métallisations 24 et 25 de base et d'émetteur ce qui permet, en très haute fréquence, de diminuer la résistance latérale de base et d'utiliser le phototransistor à la réception, dans les télécommunications par fibre optique.

Le procédé de fabrication comporte les étapes suivantes :

1. Dépôt par épitaxie (en phase liquide dans le cas des matériaux quaternaires mais éventuellement en phase gazeuse pour d'autres matériaux) de la couche 2 sur le substrat 1, le dopage de la couche 2 étant de même type de conductivité et de moindre concentration que le substrat.

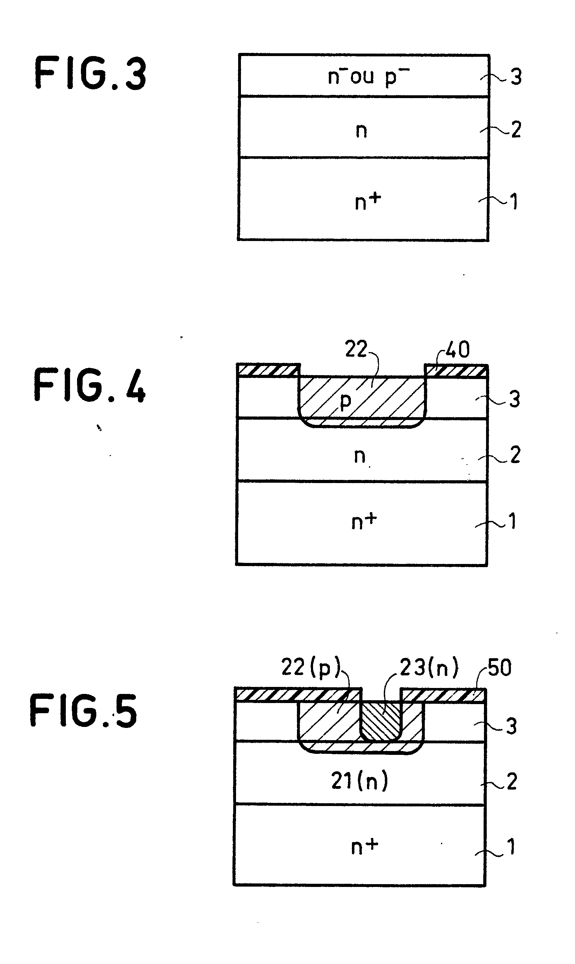

2. Dépôt par la même méthode qu'à l'étape précédente et par exemple avec le même dopage et la même concentration de dopant, de la couche 3 sur la couche 2. Le résultat obtenu est représenté à la figure 3. Le type de conductivité pourrait être du type opposé à celui de la couche 2.

3. Réalisation d'un masque de diélectrique 40 (figure 4) par photolithogravure par exemple à l'aide d'oxyde de silicium, le masque comportant une ouverture centrale de manière à constituer une fenêtre de diffusion pour l'étape suivante.

4. Diffusion d'une impureté acceptrice (Zn, Cd, Mg, Be par exemple dans le cas d'un substrat de type n) et d'une impureté de type opposé dans le cas d'un substrat de type p, de manière à créer la région 22 (figure 4) pénétrant d'un ou deux microns dans la couche 2 (région 220).

5. Réalisation d'un masque diélectrique analogue au précédent mais délimitant une ouverture plus petite qu'à la troisième étape.

6. Création, par implantation ou diffusion d'une impureté de type opposé à celui de l'impureté diffusée à la quatrième étape, de la région 23 (figure 5).

7. Finition du phototransistor par dépôt des métallisations 24, 25 et 28, puis soudure des connexions 26, 27 et 29.

Dans une variante non représentée du procédé, on forme, par épitaxie une couche monocristalline très dopée du même matériau que le substrat directement sur celui-ci, dans le même type de dopage et une concentration de $10^{17}$ à $10^{18}$ at.cm$^{-3}$. Cette couche forme tampon entre le substrat 1 et la couche 2, pour masquer des défauts éventuels du réseau cristallin du substrat.

L'invention est réalisable dans le système ternaire (Ga, Al, As, par exemple). Le substrat étant en GaAs, la première couche est alors en matériau de formule :

$$Ga_{1-z}Al_zAs$$

où l'on a

$$0 < z < 0,4$$

L'épaisseur et la concentration du dopage sont choisis dans des intervalles analogues à ceux qui ont été préconisés dans le cas du système quaternaire.

La deuxième couche est en matériau de formule :

$$Ga_{1-z'}Al_{z'}As$$

ou l'on a

$$z < z' < 1.$$

On prend par exemple : $z' = z + 0,1$.

Le procédé de fabrication est analogue. Toutefois l'épitaxie en phase gazeuse est plus facile à réaliser. En ce qui concerne le dopage n de la région 23 il peut être facilement réalisé par simple diffusion.

## Revendications

1. Phototransistor à hétérojonction du type comportant :
— un substrat (1) constitué par un premier matériau semiconducteur fortement dopé dans un premier type de conductivité ;
— une première couche semiconductrice (2) constituée par un deuxième matériau semiconducteur à bande interdite déterminée pour absorber un rayonnement de longueur d'onde prédéterminée ;
— une deuxième couche semiconductrice (3), constituée par un troisième matériau semiconducteur à bande interdite plus grande que celle du deuxième matériau ;
caractérisé en ce que :
— la première couche (2) présente un dopage moins élevé que le substrat (1) dans le même type de conductivité en ce qui concerne une première région (21) en contact avec le substrat et un dopage du type opposé dans une deuxième région (220) s'étendant à travers une partie de la surface de la première couche (2) faisant face au rayonnement incident (10) ;
— la deuxième couche (3) comporte une troisième région (23) de même type de conductivité que le substrat (1) occupant toute l'épaisseur de la deuxième couche (3) et une partie relativement faible de sa largeur, la troisième région (23) étant entourée d'une quatrième région (22) de type opposé de conductivité se raccordant à la deuxième région (220) de la première couche (2).

2. Phototransistor selon la revendication 1, caractérisé en ce que, le substrat (1) étant en phosphure d'indium monocristallin, la première couche (2) est en matériau de composition donnée par la formule :

$$Ga_xIn_{1-x}As_yP_{1-y}$$

avec

$$0,05 \leqslant x \leqslant 0,47$$

et

$$0 < y < 1$$

x et y étant choisis dans ces intervalles de façon telle que les réseaux cristallins du matériau et du substrat soient compatibles, et en ce que la deuxième couche (3) est en matériau de composition donnée par la formule :

$$Ga_{x'}In_{1-x'}As_{y'}P_{1-y'}$$

où x' et y' sont choisis dans les mêmes intervalles que les paramètres x et y, avec une condition supplémentaire qui est :

$$x' < x$$

3. Phototransistor selon la revendication 1, caractérisé en ce que, le substrat (1) étant en arséniure de gallium, la première couche (2) est en matériau de composition donné par la formule :

$$Ga_{1-z}Al_zAs$$

avec

$$0 \leqslant z \leqslant 0,4$$

la deuxième couche (3) étant en matériau de composition donnée par la formule :

$$Ga_{1-z'}Al_{z'}As$$

avec

$$z < z' \leqslant 1.$$

4. Phototransistor selon la revendication 1, caractérisé en ce qu'il comporte en outre des métallisations d'émetteur (25) de base (24) et de collecteur (28) respectivement déposées sur les faces du semiconducteur donnant accès à la troisième région (23) à la quatrième région (22) et au substrat (1).

5. Phototransistor selon la revendication 4, caractérisé en ce que la métallisation de base est interdigitée avec la métallisation d'émetteur (25), la métallisation de base (24) présentant une ouverture de forme circulaire pour laisser passer la lumière à détecter. (Fig. 6).

6. Procédé de fabrication d'un phototransistor selon l'une quelconque des revendications 1 à 5, caractérisé en ce qu'il comporte les étapes suivantes :
a) dépôt par épitaxie de la première couche (2) sur le substrat (1), la couche étant dopée dans le même type de conductivité que le substrat (1) avec une concentration moindre de dopant ;
b) dépôt par épitaxie de la deuxième couche (3) sur la première couche (2), la deuxième couche étant plus faiblement dopée que le substrat (1) dans un type de conductivité quelconque ;
c) réalisation d'un masque (40) comportant une ouverture centrale constituant une fenêtre de diffusion pour l'étape suivante ;
d) diffusion d'une impureté jusqu'à ce que le dopage pénètre dans une partie de la couche (2) de manière à créer les deuxième (220) et quatrième régions (22) de type de conductivité opposé à celui du substrat (1) ;
e) réalisation d'un masque (50) analogue au précédent mais délimitant une ouverture plus petite ;
f) création, par implantation ou diffusion dans toute l'épaisseur de la couche (3) d'une impureté de type opposé à celle de l'étape (d), de la troisième région (23) ;

g) finition du phototransistor par dépôt de métallisations et soudure de connexions.

7. Procédé selon la revendication 6, caractérisé en ce qu'il comporte une étape préliminaire au cours de laquelle on dépose par épitaxie sur le substrat (1) une couche tampon de même nature que le substrat et fortement dopé dans le même type de conductivité.

**Claims**

1. A heterojunction phototransistor of the type comprising :

— a substrate (1) constituted by a first semiconductor material heavily doped in a first conductivity type ;

— a first semiconductor layer (2) constituted by a second semiconductor material having a forbidden band which is so determined as to absorb a radiation of predetermined wavelength ;

— a second semiconductor layer (3) constituted by a third semiconductor material having a forbidden band of greater width than that of said second material, said layer being accessible from the outside through one of its large faces, characterized in that

— the first layer (2) has a lower dopant concentration than the substrate (1) but is of the same conductivity type in a first region (21) in contact with the substrate and is of opposite conductivity type in a second region (220) extending over a part of the surface of the first layer (2) which is exposed to the incident radiation (10),

— the second layer (3) has a third region (23) of the same conductivity type as the substrate (1) and occupying the entire thickness of the second layer (3) and a relatively small portion of its width, said third region (23) being surrounded by a fourth region (22) of opposite conductivity type which is joined to the second region (220) of the first layer (2).

2. A phototransistor according to claim 1, characterized in that the substrate (1) being of monocrystalline indium phosphide, the first layer (2) is of material having a composition given by the formula :

$$Ga_xIn_{1-x}As_yP_{1-y}$$

with

$$0.05 \leqslant x \leqslant 0.47$$

and

$$0 < y < 1,$$

x and y being chosen within these intervals so as to ensure that the crystal lattices of the material and of the substrate are compatible, and that the second layer (3) is of material having a composition given by the formula :

$$Ga_{x'}In_{1-x'}As_{y'}P_{1-y'}$$

where x' and y' are selected within the same intervals as the parameters x and y with an additional condition which is

$$x' < x$$

3. A phototransistor according to claim 1, characterized in that the substrate (1) being of gallium arsenide, the first layer (2) is of material having a composition given by the formula :

$$Ga_{1-z}Al_zAs$$

with

$$0 \leqslant z \leqslant 0.4$$

the second layer being of material having a composition given by the formula :

$$Ga_{1-z'}Al_{z'}As$$

with

$$z < z' \leqslant 1.$$

4. A phototransistor according to claim 1, characterized in that it further comprises emitter, base and collector metallization deposits (25, 24 and 28 respectively) formed respectively on the faces of the semiconductor which provide access to the third region (23), to the fourth region (22) and to the substrate (1).

5. A phototransistor according to claim 4, characterized in that the base metallization deposit is interdigitized with the emitter metallization deposit (25), the base metallization deposit (24) being provided with an opening of circular shape through which the light to be detected is permitted to pass.

6. A method of fabrication of a phototransistor according to any one of claims 1 to 5, characterized in that it entails the following steps :

a) deposition of the first layer (2) on the substrate (1) by epitaxial growth, the layer being doped in the same conductivity type as the substrate (1) with a lower dopant concentration ;

b) deposition of the second layer (3) on the first layer (2) by epitaxial growth, the second layer being less heavily doped than the substrate in any conductivity type ;

c) formation of a mask (40) having a central opening which constitutes a diffusion window for the following step ;

d) diffusion of an impurity until the doping enters into a part of the layer (2) in order to form the second (220) and fourth regions (22) of a conductivity type opposite to that of the substrate (1) ;

e) formation of a mask (50) which is similar to that of step c) but defines a smaller opening ;

f) formation of the third region (23) by implantation or diffusion into the entire thickness of the layer (3) of an impurity which is opposite in conductivity type to the impurity of step d) ;

g) finishing of the phototransistor by formation of metallization deposits and soldering of connections.

7. A method according to claim 6, characterized in that it comprises a preliminary step during which a buffer layer of the same composition as the substrate and heavily doped in the same conductivity type is deposited on the substrate by epotaxial growth.

**Ansprüche**

1. Heterojunktions-Phototransistor, der
— ein aus einem stark gedopten Halbleitermaterial eines ersten Leitungstyps bestehendes Substrat (1),
— eine erste Halbleiterschicht (2), bestehend aus einem zweiten Halbleitermaterial mit einem bestimmten verbotenen Band, um eine Strahlung einer vorbestimmten Wellenlänge zu absorbieren,
— und eine zweite Halbleiterschicht (3) aufweist, bestehend aus einem dritten Halbleitermaterial mit einem größeren verbotenen Band als das Band des zweiten Materials, wobei diese Schicht von außen über eine ihrer großen Oberflächen zugänglich ist,
dadurch gekennzeichnet, daß
— eine erste Zone (21) der ersten Schicht (2) in Kontakt mit dem Substrat (1) ein weniger starkes Doping und denselben Leitfähigkeitstyp wie dieses Substrat aufweist, während eine zweite Zone (220), die sich über einen Teil der der einfallenden Strahlung (10) ausgesetzten Oberfläche der ersten Schicht (2) erstreckt, ein Doping des entgegengesetzten Typs aufweist,
— die zweite Schicht (3) eine dritte Zone (23) desselben Leitfähigkeitstyps wie das Substrat (1) besitzt, die die ganze Dicke dieser zweiten Schicht (3), aber nur einen verhältnismäßig kleinen Teil der Breite besetzt, wobei diese dritte Zone (23) von einer vierten Zone (22) entgegengesetzten Leitfähigkeitstyps umgeben ist, die an die zweite Zone (220) der ersten Schicht (2) anschließt.

2. Phototransistor nach Anspruch 1, dadurch gekennzeichnet, daß bei Verwendung monokristallinen Indium-Phosphids als Material für das Substrat (1) die erste Schicht (2) aus einem Material der durch folgende Formel gegebenen Zusammensetzung besteht :

$$Ga_xIn_{1-x}As_yP_{1-y}$$

mit

$$0{,}05 \leqslant x \leqslant 0{,}47$$

und

$$0 < y < 1,$$

wobei x und y in den gegebenen Bereichen so ausgewählt werden, daß die Kristallnetze des Materials und des Substrats miteinander kompatibel sind, und daß die zweite Schicht (3) aus einem Material besteht, dessen Zusammensetzung durch folgende Formel gegeben ist :

$$Ga_{x'}In_{1-x'}As_{y'}P_{1-y'}$$

wobei x' und y' in denselben Bereichen wie die Parameter x und y unter Berücksichtigung der zusätzlichen Bedingung

$$x' < x$$

ausgewählt werden.

3. Phototransistor nach Anspruch 1, dadurch gekennzeichnet, daß bei Verwendung von Gallium-Arsenid für das Substrat (1) die erste Schicht (2) aus einem Material besteht, dessen Zusammensetzung durch folgende Formel gegeben ist :

$$Ga_{1-z}Al_zAs$$

mit

$$0 \leqslant z \leqslant 0{,}4$$

während die zweite Schicht (3) aus einem Material besteht, dessen Zusammensetzung durch folgende Formel gegeben ist :

$$Ga_{1-z'}Al_{z'}As$$

mit

$$z < z' \leqslant 1.$$

4. Phototransistor nach Anspruch 1, dadurch gekennzeichnet, daß er außerdem für den Emitter (25), die Basis (24) und den Kollektor (28) Metallisierungen aufweist, die auf die Halbleiterflächen aufgebracht sind, welche zur dritten Zone (23), zur vierten Zone (22) und zum Substrat (1) Zugang verschaffen.

5. Phototransistor nach Anspruch 4, dadurch gekennzeichnet, daß die Basismetallisierung mit der Emittermetallisierung (25) verzahnt ist, wobei die Basismetallisierung (24) eine kreisförmige Öffnung besitzt, um das zu entdeckende Licht durchzulassen.

6. Herstellungsverfahren für einen Phototransistor nach einem beliebigen der Ansprüche 1 bis 5, dadurch gekennzeichnet, daß es folgende Verfahrensschritte enthält :
a) Epitaxialabscheidung der ersten Schicht (2) auf dem Substrat (1), wobei die Schicht mit demselben Leitungstyp gedopt ist wie das Substrat (1), aber eine geringere Konzentration an Dopierstoff aufweist,
b) Epitaxialabscheidung der zweiten Schicht (3) auf der ersten Schicht (2), wobei die zweite Schicht geringer gedopt ist als das Substrat (1) und einen beliebigen Leitungstyp besitzt,
c) Herstellung einer Maske (40) mit einer zentralen, ein Diffusionsfenster bildenden Öffnung für den nachfolgenden Schritt,
d) Diffusion einer Unreinheit, bis der Dopierstoff in einen Teil der Schicht (2) eindringt, um die zweite (220) und vierte Zone (22) mit einem Leitfähigkeitstyp, der dem des Substrats (1) entgegengesetzt ist, zu bilden,

e) Herstellung einer Maske (50), die der vorhergehenden entspricht, aber eine kleinere Öffnung aufweist,

f) Bildung der dritten Zone (23) durch Implantierung oder Diffusion über die ganze Dicke der Schicht (3) von einer Unreinheit eines Leitungstyps, der dem gemäß Schritt d) entgegengesetzt ist,

g) Fertigstellung des Phototransistors durch Abscheidung der Metallisierungen und durch Anlöten der Verbindungen.

7. Verfahren nach Anspruch 6, dadurch gekennzeichnet, daß es einen vorbereitenden Verfahrensschritt aufweist, während dessen durch Epitaxie auf dem Substrat (1) eine Pufferschicht niedergeschlagen wird, die von derselben Art ist wie das Substrat und im gleichen Leitungstyp wie dieses stark gedopt ist.

0 052 033

# FIG.1

# FIG. 2

1

**FIG.3**

**FIG.4**

**FIG.5**

# FIG. 6